(19) Europäisches Patentamt
European Patent Office
Office européen des brevets

(11) **EP 4 641 222 A1**

(12) **DEMANDE DE BREVET EUROPEEN**

(43) Date de publication:
**29.10.2025 Bulletin 2025/44**

(21) Numéro de dépôt: **25172348.2**

(22) Date de dépôt: **24.04.2025**

(51) Classification Internationale des Brevets (IPC):
**G01R 19/32** [(2006.01)]   **G01R 21/14** [(2006.01)]
**G01R 15/18** [(2006.01)]

(52) Classification Coopérative des Brevets (CPC):
**G01R 21/14; G01R 19/32;** G01R 15/18

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **24.04.2024 FR 2404221**

(71) Demandeur: **SAGEMCOM ENERGY & TELECOM SAS**
**92270 Bois-Colombes (FR)**

(72) Inventeurs:
• **TEBOULLE, Henri**
**92270 BOIS-COLOMBES (FR)**
• **LEBAILLY, Lucas**
**92270 BOIS-COLOMBES (FR)**
• **DE LA CRUZ, Fabien**
**92270 BOIS-COLOMBES (FR)**

(74) Mandataire: **Cabinet Boettcher**
**5, rue de Vienne**
**75008 Paris (FR)**

(54) **ESTIMATION VIRTUELLE DE LA TEMPÉRATURE D'UN TRANSFORMATEUR DE COURANT**

(57)     Compteur électrique (1) comportant :
- un transformateur de courant (17) agencé pour produire des premières mesures d'un courant (Iph) circulant dans un enroulement (20) du transformateur de courant ;
- un capteur de température ;
- une unité de traitement (8) agencée pour évaluer un courant estimé (Ie) et une température interne (Ti), pour évaluer une température estimée (Te) de l'enroulement (20) à partir du courant estimé et de la température interne, et pour évaluer, à partir de la température estimée, un déphasage de mesure ($\Delta\varphi$) produit par le transformateur de courant sur les premières mesures, le déphasage de mesure étant destiné à être utilisé pour mesurer l'énergie électrique consommée.

**Fig. 1**

**Description**

L'invention concerne les compteurs électriques intégrant au moins un transformateur de courant.

ARRIERE PLAN

Un compteur électrique mesure l'énergie électrique fournie par un réseau de distribution (polyphasé ou monophasé) à une installation. La mesure de l'énergie électrique nécessite de mesurer le ou les courants fournis à l'installation. Pour mesurer ce ou ces courants, il est connu d'intégrer dans le compteur un ou des transformateurs de courant internes.

L'exigence de précision requise pour la mesure de l'énergie électrique consommée par l'installation est très contraignante : 0,5%, voire même jusqu'à 0,2% ou 0,1%. Cette exigence doit notamment être respectée au cours des tests d'auto-échauffement des transformateurs de courant.

On sait qu'un transformateur de courant génère un déphasage $\Delta\varphi(t)$ sur les mesures de courant, qui, s'il n'est pas compensé, provoque une imprécision importante sur la mesure de l'énergie consommée. Cette imprécision rend impossible la tenue des classes de précision qui viennent d'être évoquées.

Le déphasage $\Delta\varphi(t)$ dépend de la température des enroulements du transformateur de courant, et en particulier de la température de l'enroulement secondaire dans lequel circule l'image du courant fourni à l'installation. Il est donc nécessaire d'estimer précisément la température de l'enroulement. Ceci permet d'obtenir une estimation précise du déphasage $\Delta\varphi(t)$, et donc de compenser efficacement ce déphasage pour obtenir une mesure suffisamment précise de l'énergie consommée.

Un capteur de température est classiquement intégré dans le coffret du compteur. Il s'agit par exemple d'une thermistance de type CTN (pour Coefficient de Température Négatif). La solution la plus évidente consiste donc à utiliser cette mesure de température pour estimer le déphasage $\Delta\varphi(t)$.

Cependant, l'expérience montre que la température décroît très vite dès que l'on s'éloigne des enroulements des transformateurs et que, même si la thermistance est proche des enroulements, elle ne reflète pas fidèlement la température des enroulements. L'estimation obtenue de la température des enroulements est donc trop imprécise pour tenir les classes de précision évoquées.

On a donc envisagé de monter un capteur de température directement sur chaque transformateur. Cette solution génère un certain surcoût et une certaine complexité de conception, notamment dans les compteurs polyphasés (intégration d'un nombre de capteurs de température égal au nombre de transformateurs). Par ailleurs, les enroulements des transformateurs sont intégrés dans une gaine plastique. Le positionnement du capteur de température sur la gaine plastique fournit donc une évaluation très peu précise de la température réelle des enroulements.

OBJET

L'invention a pour objet d'évaluer le déphasage sur les mesures de courant, provoqué par un transformateur de courant intégré dans un compteur électrique, et ce, de manière précise, simple et peu coûteuse.

RESUME

En vue de la réalisation de ce but, on propose un compteur électrique, agencé pour mesurer une énergie électrique fournie à une installation par un réseau de distribution, le compteur électrique comportant :

- un dispositif de mesure de courant, comportant un transformateur de courant, et agencé pour produire des premières mesures représentatives d'un courant circulant dans un enroulement du transformateur de courant ;
- un capteur de température, agencé pour produire des deuxièmes mesures représentatives d'une température interne régnant à l'intérieur du compteur ;
- une unité de traitement agencée pour :

  ∘ évaluer un courant estimé à partir des premières mesures, et la température interne à partir des deuxièmes mesures ;
  ∘ évaluer une température estimée de l'enroulement à partir du courant estimé et de la température interne ;
  ∘ évaluer, à partir de la température estimée, un déphasage de mesure produit par le transformateur de courant sur les premières mesures, le déphasage de mesure étant destiné à être utilisé pour mesurer ladite énergie électrique.

En utilisant non seulement la température interne régnant à l'intérieur du compteur, mais aussi le courant estimé qui est évalué à partir des premières mesures produites par le dispositif de mesure de courant, l'unité de traitement est capable d'évaluer de manière très précise et en temps réel la température de l'enroulement du transformateur de courant. L'unité de traitement peut donc évaluer le déphasage de mesure très précisément, et donc produire une estimation très précise de l'énergie consommée par l'installation. Les exigences de précision drastiques, pour la mesure de l'énergie électrique consommée, sont atteintes. Cette manière d'estimer la température de l'enroulement ne nécessite pas de composant *hardware* (matériel) supplémentaire, et est donc très simple et très peu coûteuse à mettre en œuvre.

On propose de plus un compteur électrique tel que précédemment décrit, dans lequel l'unité de traitement est agencée pour appliquer un filtre passe-bas sur les premières mesures pour obtenir le courant estimé.

On propose de plus un compteur électrique tel que précédemment décrit, dans lequel le filtre passe-bas est un filtre de *Butterworth* du premier ordre.

On propose de plus un compteur électrique tel que précédemment décrit, dans lequel la température estimée est évaluée à partir du courant estimé élevé au carré.

On propose de plus un compteur électrique tel que précédemment décrit, comportant une pluralité de dispositifs de mesure de courant comprenant chacun un transformateur de courant, l'unité de traitement étant agencée, pour chaque transformateur de courant, pour évaluer la température estimée d'un enroulement dudit transformateur de courant à partir :

- de la température interne,
- du courant estimé pour ledit transformateur de courant, et
- en utilisant aussi une température approchée d'un enroulement d'au moins un autre transformateur de courant, la température approchée de l'enroulement du au moins un autre transformateur de courant étant évaluée à partir de la température interne et du courant estimé pour le au moins un autre transformateur de courant.

On propose de plus un compteur électrique tel que précédemment décrit, dans lequel le au moins un autre transformateur de courant comprend le transformateur de courant positionné le plus proche dudit transformateur de courant.

On propose de plus un compteur électrique tel que précédemment décrit, dans lequel le compteur électrique comporte un premier dispositif de mesure de courant comprenant un premier transformateur de courant et agencé pour mesurer un courant circulant sur une première phase, un deuxième dispositif de mesure de courant comprenant un deuxième transformateur de courant et agencé pour mesurer un courant circulant sur une deuxième phase, et un troisième dispositif de mesure de courant comprenant un troisième transformateur de courant et agencé pour mesurer un courant circulant sur une troisième phase,

le deuxième transformateur de courant étant positionné entre le premier transformateur de courant et le troisième transformateur de courant,

l'unité de traitement étant agencée pour :

- évaluer la température estimée de l'enroulement du premier transformateur de courant en utilisant aussi la température approchée de l'enroulement du deuxième transformateur de courant ;
- évaluer la température estimée de l'enroulement du deuxième transformateur de courant en utilisant aussi la température approchée de l'enroulement du premier transformateur de courant et la température approchée de l'enroulement du troisième transformateur de courant ;
- évaluer la température estimée de l'enroulement du troisième transformateur de courant en utilisant aussi la température approchée de l'enroulement du deuxième transformateur de courant.

On propose de plus un compteur électrique tel que précédemment décrit, le compteur électrique étant un compteur monophasé comportant un seul dispositif de mesure de courant, comprenant un transformateur de courant et agencé pour mesurer un courant circulant sur un neutre.

On propose de plus un compteur électrique tel que précédemment décrit, dans lequel :

- le ou les transformateurs de courant sont positionnés dans un premier côté parmi un côté gauche et un côté droit du compteur électrique, et dans une première partie parmi une partie haute et une partie basse du compteur électrique ;
- le capteur de température est positionné dans un deuxième côté et dans une deuxième partie du compteur électrique.

On propose de plus un procédé de mesure, mis en œuvre dans l'unité de traitement du compteur électrique tel que précédemment décrit, et comprenant les étapes de :

o évaluer un courant estimé à partir des premières mesures, et la température interne à partir des deuxièmes mesures ;
◦ évaluer une température estimée de l'enroulement à partir du courant estimé et de la température interne ;
◦ évaluer, à partir de la température estimée, un déphasage de mesure produit par le transformateur de courant sur les premières mesures, le déphasage de mesure étant destiné à être utilisé pour mesurer ladite énergie électrique.

On propose de plus un programme d'ordinateur comprenant des instructions qui conduisent l'unité de traitement du compteur électrique tel que précédemment décrit à exécuter les étapes du procédé de mesure tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit de modes de mise en œuvre particuliers non limitatifs de l'invention.

BREVE DESCRIPTION DES DESSINS

Il sera fait référence aux dessins annexés parmi lesquels :

[Fig. 1] la figure 1 représente schématiquement un compteur électrique et illustre la calibration du module de mesure du compteur ;

[Fig. 2] la figure 2 est une vue de face simplifiée du compteur, sans le capot qui ferme le coffret du compteur ; [Fig. 3] la figure 3 est un graphique comprenant une courbe de la température (en °C) d'un enroulement d'un transformateur de courant en fonction du temps, et une courbe du courant (en A) circulant dans l'enroulement en fonction du temps.

DESCRIPTION DETAILLEE

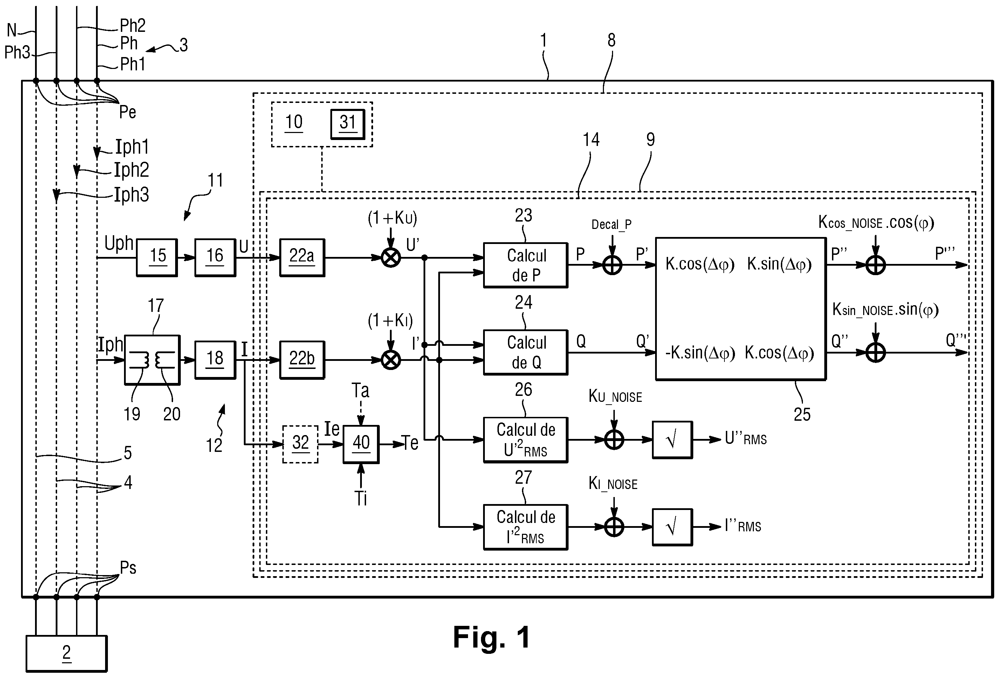

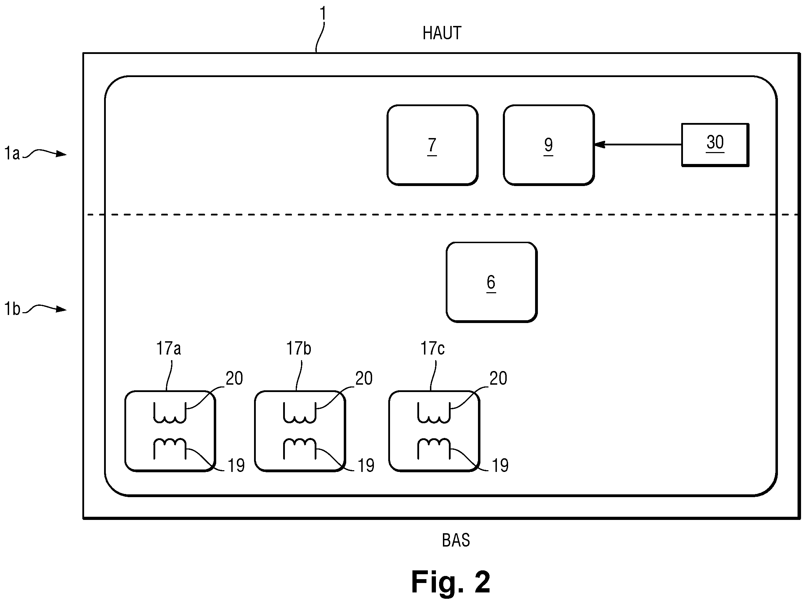

En référence aux figures 1 et 2, le compteur électrique 1 est ici un compteur triphasé qui est destiné à mesurer l'énergie électrique fournie à l'installation électrique 2 d'un abonné par un réseau de distribution 3.

Le réseau de distribution 3 comprend trois phases Ph (Ph1, Ph2 et Ph3), et un neutre N.

Le compteur 1 comprend trois ports d'entrée Pe connectés chacun à l'une des phases Ph du réseau de distribution 3, et un port d'entrée Pe connecté au neutre N. Le compteur 1 comporte aussi quatre ports de sortie Ps connectés à l'installation 2 (trois pour les phases et un pour le neutre).

Le compteur 1 comprend trois conducteurs de phase 4 reliés chacun à l'une des phases Ph, et un conducteur de neutre 5 relié au neutre N.

Le compteur 1 intègre un organe de coupure 6 (visible sur la figure 2) comprenant, pour chaque phase Ph, un interrupteur monté sur le conducteur de phase 4 associé. L'organe de coupure 6 est notamment utilisé pour couper ou rétablir à distance l'alimentation de l'installation 2 en cas, par exemple, de résiliation de l'abonnement ou de non-respect du contrat d'abonnement.

Le compteur 1 comporte une partie dite « applicative » et une partie dite « métrologie ».

La partie applicative comprend un microcontrôleur applicatif 7 qui, notamment, pilote l'organe de coupure 6.

La partie métrologie comprend une unité de traitement 8 (électronique et logicielle). L'unité de traitement 8 comprend au moins un composant de traitement 9, qui est par exemple un processeur « généraliste », un processeur spécialisé dans le traitement du signal (ou DSP, pour *Digital Signal Processor*), un microcontrôleur, ou bien un circuit logique programmable tel qu'un FPGA (pour *Field Programmable Gate Arrays*) ou un ASIC (pour *Application Specific Integrated Circuit*). L'unité de traitement 8 comprend aussi une ou des mémoires 10, reliées au composant de traitement 9, ou intégrées dans le composant de traitement 9. Au moins l'une de ces mémoires 10 forme un support d'enregistrement lisible par ordinateur, sur lequel est enregistré au moins un programme d'ordinateur comprenant des instructions qui conduisent l'unité de traitement 8 à exécuter les étapes du procédé de mesure qui sera décrit plus bas.

Ici, l'unité de traitement 8 comprend un microcontrôleur métrologie 9. C'est dans le microcontrôleur métrologie 9 qu'est mis en œuvre le procédé de mesure.

Outre l'unité de traitement 8, la partie métrologie comprend, pour chaque phase Ph du réseau de distribution 3, un dispositif de mesure de tension 11, un dispositif de mesure de courant 12, et un module de mesure 14. Sur la figure 1, les éléments 11, 12, 14 (et leurs composants) sont représentés pour une phase Ph uniquement, mais le compteur 1 comprend de tels éléments pour chacune des phases Ph.

Le dispositif de mesure de tension 11 comprend des résistances 15 formant un pont diviseur de tension, et une chaîne de mesure de tension 16. Le pont diviseur de tension permet de produire, à partir de la tension Uph de la phase Ph du réseau 3, une tension inférieure ou égale à 3,3V. La chaîne de mesure de tension 16 comporte un convertisseur analogique-numérique. La chaîne de mesure de tension 16 produit des mesures de la tension de phase Uph présente sur la phase Ph associée.

Le dispositif de mesure de courant 12 comporte un transformateur de courant 17 et une chaîne de mesure de courant 18 reliée au transformateur de courant 17.

Le transformateur de courant 17 comprend un enroulement primaire 19, dans lequel circule le courant de phase Iph, et un enroulement secondaire 20.

Chaque enroulement 19, 20 peut comprendre un nombre quelconque de spires.

L'enroulement primaire 19 est préférentiellement le conducteur de phase 4 lui-même, et comprend donc dans ce cas une seule spire. Le transformateur 17 est alors par exemple un transformateur de courant ouvrant constituant un tore sur lequel l'enroulement secondaire est enroulé sous forme de spires tout au long du tore à travers lequel passe le conducteur de phase 4. Il peut s'agir aussi d'un capteur de *Rogowski*.

La chaîne de mesure de courant 18 comprend préférentiellement une résistance suivie d'un convertisseur analogique-numérique, relié à l'enroulement secondaire 20 du transformateur de courant 17, et des éventuels composants électroniques supplémentaires pouvant comprendre un ou plusieurs amplificateurs. La chaîne de mesure de courant 18 produit des premières mesures représentatives du courant circulant dans l'enroulement primaire et fourni à l'installation 2. Il s'agit donc du courant de phase Iph circulant sur la phase Ph.

On a donc dans le compteur un premier transformateur de courant 17a utilisé pour mesurer le premier courant de phase Iph1, un deuxième transformateur de courant 17b utilisé pour mesurer le deuxième courant de phase Iph2, et un troisième transformateur de courant 17c utilisé pour mesurer le troisième courant de phase Iph3.

Le module de mesure 14 est un module numérique, qui est implémenté dans le microcontrôleur de métrologie 9 du compteur 1. Le module de mesure 14 est relié à la chaîne de mesure de tension 16 et à la chaîne de mesure de courant 18.

Le module de mesure 14 comprend, dans le cas de mesures en fondamental, des filtres passe-bas 22a, 22b agencés pour supprimer des harmoniques de la tension de phase et du courant de phase de manière à produire une tension de phase en fondamental et un courant de phase en fondamental. Dans le cas de mesures avec harmoniques, on supprime les filtres passe-bas 22a et 22b.

Le module de mesure 14 comprend de plus une pluralité de modules de calcul, qui permettent d'évaluer la puissance active, la puissance réactive, la tension RMS (pour Root *Mean Square* ; il s'agit de la valeur efficace) et le courant RMS distribués par le réseau de distribution 3 via la phase Ph.

Pour chaque phase Ph, la mesure de ces grandeurs permet d'évaluer l'énergie électrique fournie à l'installation 2 par le réseau de distribution 3.

Le module de mesure 14 utilise un certain nombre de paramètres de calibration pour réaliser ces calculs. Les paramètres de calibration sont les suivants : $K_U$, $K_I$, *Decal_P*, $K_{U\_NOISE}$, $K_{I\_NOISE}$, $K_{COS\_NOISE} \cdot cos(\varphi)$, $K_{SIN\_NOISE} \cdot sin(\varphi)$, **K**, $\Delta\varphi$.

La tension de phase **U** est multipliée par un facteur multiplicatif intégrant le paramètre de tension $K_U$, pour obtenir une tension compensée **U'**. Le facteur multiplicatif est égal à **(1 + $K_U$)**.

Le courant de phase **I** est multiplié par un facteur multiplicatif intégrant le paramètre de courant $K_I$, pour obtenir un courant compensé **I'**. Le facteur multiplicatif est égal à **(1 + $K_I$)**.

Le module 23 acquiert la tension compensée **U'** et le courant compensé **I'** et produit une puissance active brute **P**.

Le paramètre **Decal_P** est ajouté à la puissance active brute **P** pour obtenir une puissance active **P'**.

Le module 24 acquiert la tension compensée **U'** et le courant compensée **I'** et produit une puissance réactive brute **Q**.

Le module 25, qui se présente sous la forme d'une matrice, acquiert la puissance active **P'** et la puissance réactive **Q'** (ici égale à **Q**) et évalue la puissance active compensée **P″** et la puissance réactive compensée **Q″**, en calculant :

$$P'' = K.cos(\Delta\varphi).P' + K.sin(\Delta\varphi).Q'$$

$$Q'' = -K.sin(\Delta\varphi).P' + K.cos(\Delta\varphi).Q'$$

Le paramètre $K_{COS\_NOISE} \cdot cos(\varphi)$ est ajouté à la puissance active compensée **P″** pour obtenir la puissance active **P‴**.

Le paramètre $K_{SIN\_NOISE} \cdot sin(\varphi)$ est ajouté à la puissance réactive compensée **Q″** pour obtenir la puissance réactive **Q‴**.

Le module 26 acquiert la tension compensée **U'** et calcule la tension RMS au carré : $U'^2_{RMS}$. Le paramètre $K_{U\_NOISE}$ est ajouté à la tension RMS au carré, puis la racine du résultat de cette addition est calculée, pour obtenir la tension RMS compensée $U''_{RMS}$.

Le module 27 acquiert le courant compensé et calcule le courant RMS au carré : $I'^2_{RMS}$. Le paramètre $K_{I\_NOISE}$ est ajouté au courant RMS au carré, puis la racine du résultat de cette addition est calculée, pour obtenir le courant RMS compensé $I''_{RMS}$.

Les paramètres de calibration utilisés par le module de mesure 14 permettent notamment de compenser les variations de gain sur la tension de phase, dues aux composants de la chaîne de mesure de tension 16, les variations de gain sur le courant de phase, dues aux composants de la chaîne de mesure de courant 18, les effets du bruit blanc intrinsèque au compteur 1, les bruits de quantification du convertisseur analogique-numérique de la chaîne de mesure de tension 16 et du convertisseur analogique-numérique de la chaîne de mesure de courant 18, les variations de gain de la chaîne de mesure de tension 16 et de la chaîne de mesure de courant 18, etc.

Les paramètres de calibration commençant par « *K* » ainsi que *Decal_P* sont fixes et calibrés en usine.

Le paramètre de calibration $\Delta\varphi(t)$, quant à lui, permet de compenser les variations de phase de la chaîne de mesure de courant 18, dues au transformateur de courant 17.

Il s'agit donc d'un déphasage de mesure produit par le transformateur de courant 17 sur les premières mesures, qui sont produites par le dispositif de mesure de courant 12 et qui sont représentatives du courant de phase Iph fourni à l'installation 2 et circulant dans l'enroulement primaire 19 du transformateur de courant 17.

Ce déphasage de mesure $\Delta\varphi(t)$ est variable et n'est pas calibré en usine. Il dépend de la température de l'enroulement 20 du transformateur de courant 17.

Le déphasage de mesure $\Delta\varphi(t)$ est estimé en temps réel par l'unité de traitement 8 du compteur 1.

Le compteur 1 intègre un capteur de température 30, qui est ici une thermistance de type CTN. La thermistance 30 est connectée au microcontrôleur métrologie 9 de l'unité de traitement 8. La thermistance 30 produit des deuxièmes mesures représentatives d'une température interne régnant à l'intérieur du compteur 1.

Pour chaque transformateur de courant 17, l'unité de traitement 8 va donc évaluer le déphasage de mesure $\Delta\varphi(t)$ de la manière suivante.

L'unité de traitement 8 évalue tout d'abord un courant estimé Ie à partir des premières mesures (produites par le dispositif de mesure de courant 12), et la température interne Ti régnant dans le compteur 1 à partir des deuxièmes mesures (produites par la thermistance 30).

Puis, un module de calcul 40 du module de mesure 14 de l'unité de traitement 8 évalue une température estimée Te de l'enroulement secondaire 20 à partir du courant estimé Ie et de la température interne Ti. L'unité de traitement 8 évalue alors le déphasage de mesure $\Delta\varphi(t)$, produit par le transformateur de courant 17 sur les premières mesures, à partir de la température estimée de l'enroulement secondaire 20 du transformateur de courant 17. Le déphasage de mesure est destiné, comme on l'a vu, à être utilisé pour mesurer l'énergie électrique fournie à l'installation 2 par le réseau de distribution 3.

Le déphasage de mesure $\Delta\varphi(t)$ peut être déduit de la température estimée de l'enroulement secondaire 20 à partir des données fabricant du transformateur 17. Une table de correspondance 31 est par exemple stockée dans l'une des mémoires 10 de l'unité de traitement 8. Cette table de correspondance 31 associe des valeurs de déphasage à des valeurs de température de l'enroulement secondaire 20.

Dans un premier mode de réalisation, le courant estimé Ie est le courant I qui correspond aux premières mesures produites par le dispositif de mesure 12. La température estimée de l'enroulement est par exemple évaluée à partir du courant estimé élevé au carré ; on utilise une analogie avec la dissipation thermique d'une résistance en $RI^2$.

On a alors par exemple :

$$TC1(t) = CTN(t) + K1.I1(t)^2$$

$$TC2(t) = CTN(t) + K2.I2(t)^2$$

$$TC3(t) = CTN(t) + K3.I3(t)^2$$

où *TC1*(*t*) est la température estimée (en temps réel) de l'enroulement secondaire 20 du premier transformateur 17a de la première phase Ph1, *I1*(*t*) est le courant estimé pour le premier transformateur 17a, *K1* est un facteur fixe déterminé par conception, et *CTN*(*t*) est la température interne,

où *TC2*(*t*) est la température estimée (en temps réel) de l'enroulement secondaire 20 du deuxième transformateur 17b de la deuxième phase Ph2, *I2*(*t*) est le courant estimé pour le deuxième transformateur 17b, *K2* est un facteur fixe déterminé par conception, et *CTN*(*t*) est la température interne,

et où *TC3*(*t*) est la température estimée (en temps réel) de l'enroulement secondaire 20 du troisième transformateur 17c de la troisième phase Ph3, $I3(t)$ est le courant estimé pour le troisième transformateur 17c, $K3$ est un facteur fixe déterminé par conception, et $CTN(t)$ est la température interne.

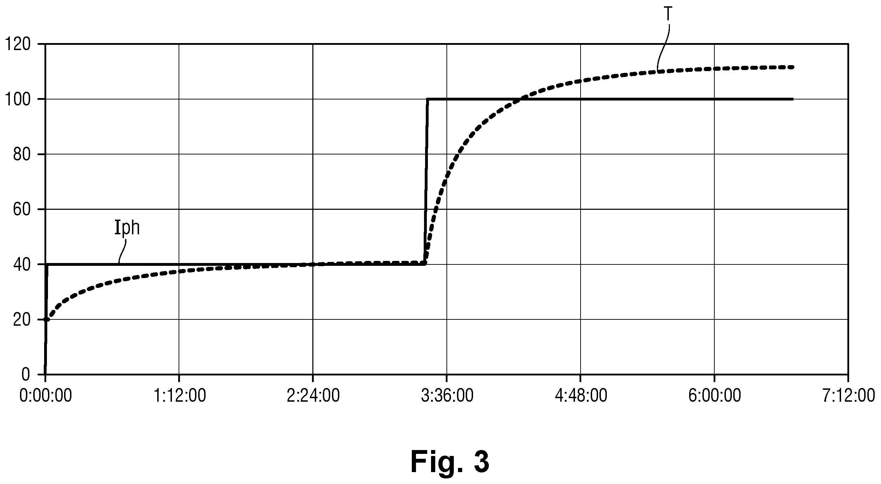

On voit sur la figure 3 la manière dont varie la température réelle T de l'enroulement secondaire 20 d'un transformateur de courant 17, alors qu'un courant de phase Iph tout d'abord nul, puis égal à 40A, puis égal à 100A, circule dans l'enroulement primaire 19. Cette figure 3 a été obtenue au cours de tests d'auto-échauffement des transformateurs de courant 17. Un certain délai est nécessaire pour que la température de l'enroulement atteigne un niveau constant qui correspond à l'échelon de courant appliqué (environ 40°C pour l'échelon de 40A, et environ 112°C pour l'échelon de 100A).

Dans un deuxième mode de réalisation, le courant estimé Ie, à partir duquel est évalué le déphasage de mesure $\Delta\varphi(t)$, n'est cette fois plus directement le courant correspondant aux premières mesures. Cette fois, pour tenir compte des phases transitoires, l'unité de traitement 8 applique un filtre passe-bas 32 sur les premières mesures pour obtenir le courant estimé Ie.

L'application du filtre passe-bas 32 sur le courant I(t), et dont la sortie est I' (t), permet de lisser la courbe pour s'approcher au plus près à la réalité où la température d'enroulement met un certain temps à se stabiliser. La température estimée Te, en fonction du temps, de l'enroulement secondaire 20, obtenue par cette méthode, est plus proche de la température réelle de l'enroulement.

On obtient donc :

$$TC1(t) = CTN(t) + K1.I'1(t)^2$$

$$TC2(t) = CTN(t) + K2.I'2(t)^2$$

$$TC3(t) = CTN(t) + K3.I'3(t)^2$$

où $TC1(t)$ est la température estimée (en temps réel) de l'enroulement secondaire 20 du premier transformateur 17a de la première phase Ph1, $I'1(t)$ est le courant estimé pour le premier transformateur 17a (premières mesures sur lesquelles le filtre passe-bas 32 a été appliqué), $K1$ est un facteur fixe déterminé par conception, et $CTN(t)$ est la température interne,

où $TC2(t)$ est la température estimée (en temps réel) de l'enroulement secondaire 20 du deuxième transformateur 17b de la deuxième phase Ph2, $I'2(t)$ est le courant estimé pour le deuxième transformateur 17b (premières mesures sur lesquelles le filtre passe-bas 32 a été appliqué), $K2$ est un facteur fixe déterminé par conception, et $CTN(t)$ est la température interne,

et où $TC3(t)$ est la température estimée (en temps réel) de l'enroulement secondaire 20 du troisième transformateur 17c de la troisième phase Ph3, $I'3(t)$ est le courant estimé pour le troisième transformateur 17c (premières mesures sur lesquelles le filtre passe-bas 32 a été appliqué), $K3$ est un facteur fixe déterminé par conception, et $CTN(t)$ est la température interne.

Le filtre passe-bas 32 utilisé est par exemple un filtre de *Butterworth* d'ordre 1. On cherche à filtrer $I(Z)$ de manière à obtenir en sortie du filtre linéaire $H(Z)$:

$$I'(Z) = I(Z).H(Z)$$

La transformée en Z d'un filtre de Butterworth du 1er ordre s'exprime par la relation :

$$H(Z) = G.\frac{1+Z^{-1}}{1-a.Z^{-1}} \text{ avec } Z = e^{\frac{j.2.\pi.f}{f_E}}$$

On suppose qu'on échantillonne le courant I(t) numériquement à la fréquence de 1Hz.

On choisit le paramètre $a$ de manière à ce que le temps de montée soit compatible avec la conception et que le gain du filtre soit égal à 1.

On choisit ici $a = 0.9993606$ et $G = 0.0003197$ pour avoir un temps de montée à 90% de 1h et un gain de 1.

Dans un troisième mode de réalisation, l'unité de traitement 8 évalue, pour chaque transformateur de courant 17, la température estimée Te de l'enroulement 20 dudit transformateur de courant 17 à partir :

- de la température interne Ti (thermistance 30),
- du courant estimé Ie pour ledit transformateur de courant, et
- en utilisant aussi une température approchée Ta de l'enroulement secondaire 20 d'au moins un autre transformateur de courant 17, la température approchée Ta de l'enroulement secondaire 20 du au moins un autre transformateur de courant 17 étant évaluée à partir de la température interne Ti et du courant estimé Ie pour le au moins un autre transformateur de courant 17.

Dans ce mode de réalisation, la « température approchée » correspond donc à la « température estimée » des précédents modes de réalisation.

Le au moins un autre transformateur de courant comprend le transformateur de courant positionné le plus proche dudit transformateur de courant.

Ici, le compteur électrique 1 comporte un premier transformateur de courant 17a, un deuxième transformateur de courant 17b et un troisième transformateur de courant 17c.

Les transformateurs 17a, 17b, 17c des phases Ph1, Ph2 et Ph3 sont alignés dans cet ordre. On voit sur la figure 2 le premier transformateur 17a sur la gauche, le deuxième transformateur 17b au milieu des deux autres et le troisième transformateur 17c sur la droite. Le deuxième transformateur de courant 17b est donc positionné entre le premier transformateur de courant 17a et le troisième transformateur de courant 17c.

On peut considérer que le deuxième transformateur 17b, lorsqu'il est traversé par un courant fort (au moins quelques dizaines d'ampères), peut élever la température à proximité du premier transformateur 17a et du troisième transformateur 17c.

Le premier transformateur 17a, lorsqu'il est traversé par un courant fort, peut élever la température à proximité du deuxième transformateur 17b. Le troisième transformateur 17c, lorsqu'il est traversé par un courant fort, peut également élever la température autour du deuxième transformateur 17b.

Ainsi, l'unité de traitement 8 :

- évalue la température estimée de l'enroulement secondaire 20 du premier transformateur de courant 17a en utilisant aussi la température approchée de l'enroulement secondaire 20 du deuxième transformateur de courant 17b ;
- évalue la température estimée de l'enroulement secondaire 20 du deuxième transformateur de courant 17b en utilisant aussi la température approchée de l'enroulement secondaire 20 du premier transformateur de courant 17a et la température approchée de l'enroulement secondaire 20 du troisième transformateur de courant 17c ;
- évalue la température estimée de l'enroulement secondaire 20 du troisième transformateur de courant 17c en utilisant aussi la température approchée de l'enroulement secondaire 20 du deuxième transformateur de courant 17b.

Ainsi, par rapport aux formules précédemment utilisées, on ne prend plus en compte, pour évaluer la température ambiante, uniquement la valeur de la température mesurée par la thermistance 30, mais plutôt une température dérivée de celle de la thermistance 30 et de celles des transformateurs 17.

On continue donc à estimer les températures approchées $TC1(t)$, $TC2(t)$ et $TC3(t)$ comme précédemment, mais on en déduit les températures estimées (en temps réel) $TC'1(t)$, $TC'2(t)$ et $TC'3(t)$ de la manière suivante.

Dans le cas du premier transformateur 17a, on remplace dans la formule le terme $CTN(t)$ par $(CTN(t) + TC2(t))/2$ et on détermine la température estimée $TC'1(t)$, qui est telle que :

$$TC'1(t) = (CTN(t) + TC2(t))/2 + K1.I'1(t)^2$$

Dans le cas du deuxième transformateur 17b, on remplace dans la formule le terme $CTN(t)$ par $(CTN(t) + (TC1(t) + TC3(t))/2)/2$ et on détermine la température estimée $TC'2(t)$, qui est telle que:

$$TC'2(t) = (CTN(t) + (TC1(t) + TC3(t))/2)/2 + K2.I'2(t)^2$$

Dans le cas du troisième ransformateur 17c, on remplace dans la formule le terme $CTN$ par $(CTN(t) + TC2(t))/2$ et on détermine la température cpmpensée $TC'3(t)$ te que:

$$TC'3(t) = (CTN(t) + TC2(t))/2 + K3.I'3(t)^2$$

Ce sont alors les températures estimées $TC'1(t)$, $TC'2(t)$ et $TC'3(t)$ qui sont prises en compte pour déterminer les déphasages de mesure respectifs $\Delta\varphi1(t)$, $\Delta\varphi2(t)$ et $\Delta\varphi3(t)$.

Ce mode de réalisation est le mode préférentiel en triphasé, car c'est celui qui apporte la meilleure précision.

Les premier et deuxième modes de réalisation décrits s'appliquent bien sûr dans le cas d'un compteur monophasé. Typiquement, un compteur monophasé comporte un seul transformateur de courant, utilisé pour mesurer le courant circulant sur le neutre (le courant de phase étant de préférence mesuré par un *shunt).*

La température estimée est telle que :

$$TCN(t) = CTN(t) + KN.IN(t)^2$$

Dans ce cas, le courant estimé $IN(t)$ est obtenu directement à partir des premières mesures produites par le dispositif de mesure de courant qui mesure le courant de neutre.

Alternativement, et de préférence, on obtient la température estimée ainsi :

$$TCN(t) = CTN(t) + KN.I'N(t)^2$$

Dans ce cas, le courant estimé $I'N(t)^2$ est le courant correspondant aux premières mesures, sur lesquelles on a appliqué le filtre passe-bas 32.

On s'intéresse maintenant aux positions des différents éléments dans le compteur 1. Il est préférable que la thermistance 30 soit positionnée dans le coffret du compteur 1 en étant le plus éloignée possible des points chauds, c'est-à-dire en l'occurrence du ou des transformateurs de courant 17 et de l'organe de coupure 6.

Ainsi, avantageusement :

- le ou les transformateurs de courant 17 et l'organe de coupure 6 sont positionnés dans un premier côté parmi un côté gauche et un côté droit du coffret du compteur électrique 1, et dans une première partie parmi une partie haute 1a et une partie basse 1b du compteur électrique 1 ;
- la thermistance 30 est positionnée dans un deuxième côté et dans une deuxième partie du compteur électrique 1.

Les termes « haute », « basse », « gauche », « droite » correspondent à une situation dans laquelle le compteur est positionné dans sa position nominale de fonctionnement (ici, en ayant sa face arrière positionnée contre un support vertical).

Le ou les transformateurs 17 et l'organe de coupure 6 sont de préférence positionnés dans la partie basse 1b du compteur électrique 1, par exemple à gauche, et la thermistance 30 est positionnée de préférence dans la partie haute 1a du compteur électrique 1, et donc à droite dans cet exemple.

Le ou les transformateurs de courant 17 et l'organe de coupure 6, d'une part, et la thermistance 30, d'autre part, sont de préférence situés dans des parties diagonalement opposées du volume interne du compteur 1.

Dans le cas où le ou les transformateurs de courant 17, l'organe de coupure 6 et la thermistance 30 sont montés sur une même carte électrique, ils sont situés dans des parties diagonalement opposées de ladite carte.

Bien entendu, l'invention n'est pas limitée aux modes de réalisation décrits mais englobe toute variante entrant dans le champ de l'invention tel que défini par les revendications.

Les formules utilisées pourraient être différentes de celles données ici.

Par exemple, la température estimée de l'enroulement d'un transformateur pourrait être évaluée à partir du courant estimé élevé au cube et non au carré.

Il est possible d'ajouter des coefficients dans toutes les formules.

On pourrait avoir par exemple :

$$TC1(t) = \alpha.CTN(t) + K1.I1(t)^2$$

Le compteur peut être un compteur monophasé, triphasé ou, plus généralement, polyphasé.

La température estimée, à partir de laquelle le déphasage de mesure est évalué, peut être la température d'un enroulement primaire du transformateur de courant. Dans ce cas, le courant estimé, utilisé pour évaluer la température estimée, est évalué à partir de mesures représentatives du courant circulant dans cet enroulement primaire.

**Revendications**

1. Compteur électrique (1), agencé pour mesurer une énergie électrique fournie à une installation (2) par un réseau de distribution (3), le compteur électrique (1) comportant :

  - un dispositif de mesure de courant (12), comportant un transformateur de courant (17), et agencé pour produire des premières mesures représentatives d'un courant (Iph) circulant dans un enroulement (20) du transformateur de courant ;
- un capteur de température (30), agencé pour produire des deuxièmes mesures représentatives d'une température interne (Ti) régnant à l'intérieur du compteur ;
- une unité de traitement (8) agencée pour :

  ◦ évaluer un courant estimé (Ie) à partir des premières mesures, et la température interne (Ti) à partir des deuxièmes mesures ;
  ◦ évaluer une température estimée (Te) de l'enroulement (20) à partir du courant estimé et de la température interne ;
  ◦ évaluer, à partir de la température estimée, un déphasage de mesure ($\Delta\varphi$) produit par le transformateur de courant sur les premières mesures, le déphasage de mesure étant destiné à être utilisé pour mesurer ladite énergie électrique.

2. Compteur électrique selon la revendication 1, dans lequel l'unité de traitement (8) est agencée pour appliquer un filtre passe-bas (32) sur les premières mesures pour obtenir le courant estimé (Ie).

3. Compteur électrique selon la revendication 2, dans lequel le filtre passe-bas (32) est un filtre de *Butterworth* du premier ordre.

4. Compteur électrique selon l'une des revendications précédentes, dans lequel la température estimée (Te) est évaluée à partir du courant estimé (Ie) élevé au carré.

5. Compteur électrique selon l'une des revendications précédentes, comportant une pluralité de dispositifs de mesure de courant (12) comprenant chacun un transformateur de courant (17), l'unité de traitement (8) étant agencée, pour chaque transformateur de courant (17), pour évaluer la température estimée d'un enroulement (20) dudit transformateur de courant à partir :

  - de la température interne,
  - du courant estimé pour ledit transformateur de courant, et
  - en utilisant aussi une température approchée d'un enroulement d'au moins un autre transformateur de courant, la température approchée de l'enroulement du au moins un autre transformateur de courant étant évaluée à partir de la température interne et du courant estimé pour le au moins un autre transformateur de courant.

6. Compteur électrique selon la revendication 5, dans lequel le au moins un autre transformateur de courant comprend le transformateur de courant positionné le plus proche dudit transformateur de courant.

7. Compteur électrique selon la revendication 6, dans lequel le compteur électrique (1) comporte un premier dispositif de mesure de courant comprenant un premier transformateur de courant (17a) et agencé pour mesurer un courant (Iph1) circulant sur une première phase (Ph1), un deuxième dispositif de mesure de courant comprenant un deuxième transformateur de courant (17b) et agencé pour mesurer un courant (Iph2) circulant sur une deuxième phase (Ph2), et un troisième dispositif de mesure de courant comprenant un troisième transformateur de courant (17c) et agencé pour mesurer un courant (Iph3) circulant sur une troisième phase (Ph3),

le deuxième transformateur de courant (17b) étant positionné entre le premier transformateur de courant (17a) et le troisième transformateur de courant (17c),
l'unité de traitement (8) étant agencée pour :

  - évaluer la température estimée de l'enroulement du premier transformateur de courant (17a) en utilisant aussi la température approchée de l'enroulement du deuxième transformateur de courant (17b) ;
  - évaluer la température estimée de l'enroulement du deuxième transformateur de courant (17b) en utilisant aussi la température approchée de l'enroulement du premier transformateur de courant (17a) et la température approchée de l'enroulement du troisième transformateur de courant (17c) ;
  - évaluer la température estimée de l'enroulement du troisième transformateur de courant (17c) en utilisant aussi la température approchée de l'enroulement du deuxième transformateur de courant (17b).

8. Compteur électrique selon l'une des revendications 1 à 4, le compteur électrique étant un compteur monophasé comportant un seul dispositif de mesure de courant, comprenant un transformateur de courant et agencé pour mesurer un courant circulant sur un neutre.

9. Compteur électrique (1) selon l'une des revendications précédentes, dans lequel :

- le ou les transformateurs de courant sont positionnés dans un premier côté parmi un côté gauche et un côté droit du compteur électrique, et dans une première partie (1b) parmi une partie haute (1a) et une partie basse (1b) du compteur électrique ;
- le capteur de température (30) est positionné dans un deuxième côté et dans une deuxième partie (1a) du compteur électrique.

10. Procédé de mesure, mis en œuvre dans l'unité de traitement (8) du compteur électrique (1) selon l'une des revendications précédentes, et comprenant les étapes de :

◦ évaluer un courant estimé (Ie) à partir des premières mesures, et la température interne (Ti) à partir des deuxièmes mesures ;
◦ évaluer une température estimée (Te) de l'enroulement (20) à partir du courant estimé et de la température interne ;
◦ évaluer, à partir de la température estimée, un déphasage de mesure ($\Delta\varphi$) produit par le transformateur de courant sur les premières mesures, le déphasage de mesure étant destiné à être utilisé pour mesurer ladite énergie électrique.

11. Programme d'ordinateur comprenant des instructions qui conduisent l'unité de traitement (8) du compteur électrique (1) selon l'une des revendications 1 à 9 à exécuter les étapes du procédé de mesure selon la revendication 10.

12. Support d'enregistrement lisible par ordinateur, sur lequel est enregistré le programme d'ordinateur selon la revendication 11.

Fig. 1

Fig. 2

Fig. 3

Europäisches
Patentamt

European
Patent Office

Office européen
des brevets

**RAPPORT DE RECHERCHE EUROPEENNE**

Numéro de la demande

EP 25 17 2348

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 01/55733 A1 (ABB AUTOMATION INC [US]) 2 août 2001 (2001-08-02) | 1-4,8-12 | INV. G01R19/32 G01R21/14 |
| A | * page 6, ligne 25 - page 8, ligne 10; figures 1,2B * | 5-7 | |
| | ----- | | ADD. G01R15/18 |
| A | MANISH DAS: "P DOCVARIABLE varDesignation \* MERGEFORMAT C37", IEEE DRAFT WGDS; 1206036968375, IEEE-SA IMEET CENTRAL, PISCATAWAY, NJ USA , vol. C37.102 27 avril 2023 (2023-04-27), pages 1-208, XP068283035, Extrait de l'Internet: URL:https://ieee-sa.imeetcentral.com/p/aQA AAAAFCufL [extrait le 2023-05-04] * Section 4.2.1.1 * | 1-12 | |
| | ----- | | |
| A | GARY HOFFMAN: "IEEE-TRANSACTION-PAPERS.zip.pdf", IEEE DRAFT WGDS; 853685828578, IEEE-SA IMEET CENTRAL, PISCATAWAY, NJ USA , vol. C57.163 8 décembre 2013 (2013-12-08), page 1, XP068302176, Extrait de l'Internet: URL:https://ieee-sa.imeetcentral.com/p/aQA AAAAB-5uX [extrait le 2014-07-25] * page 1073 * | 1-12 | **DOMAINES TECHNIQUES RECHERCHES (IPC)** G01R |
| | ----- | | |
| | -/-- | | |

Le présent rapport a été établi pour toutes les revendications

| Lieu de la recherche | Date d'achèvement de la recherche | Examinateur |
|---|---|---|
| Munich | 5 mai 2025 | Meliani, Chafik |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................
& : membre de la même famille, document correspondant

EPO FORM 1503 03.82 (P04C02)

Europäisches
Patentamt

European
Patent Office

Office européen
des brevets

# RAPPORT DE RECHERCHE EUROPEENNE

Numéro de la demande

EP 25 17 2348

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | GALDI V ET AL: "Neural diagnostic system for transformer thermal overload protection", IEE PROCEEDINGS: ELECTRIC POWER APPLICATIONS, INSTITUTION OF ELECTRICAL ENGINEERS, GB, vol. 147, no. 5, 8 septembre 2000 (2000-09-08), pages 415-421, XP006014139, ISSN: 1350-2352, DOI: 10.1049/IP-EPA:20000519 * page 415 - page 416 * ----- | 1-12 | |
| A | CN 111 989 901 B (ABB SCHWEIZ AG) 18 avril 2023 (2023-04-18) * revendication 1 * ----- | 1-12 | |
| A | GB 2 538 816 A (SECURE INT HOLDINGS PTE LTD [SG]) 30 novembre 2016 (2016-11-30) * revendication 1; figures 4,6 * ----- | 1-12 | DOMAINES TECHNIQUES RECHERCHES (IPC) |
| A | CN 204 758 133 U (SHANGHAI HINNER TECHNOLOGY CO LTD) 11 novembre 2015 (2015-11-11) * revendication 1 * ----- | 1-12 | |
| A | US 2024/118326 A1 (FERGUSON KEVIN R [US] ET AL) 11 avril 2024 (2024-04-11) * alinéa [0030] * ----- | 1-12 | |
| A | EP 4 113 131 A1 (SAGEMCOM ENERGY & TELECOM SAS [FR]) 4 janvier 2023 (2023-01-04) * alinéa [0019] - alinéa [0020] * ----- | 1-12 | |

Le présent rapport a été établi pour toutes les revendications

| Lieu de la recherche | Date d'achèvement de la recherche | Examinateur |
|---|---|---|
| Munich | 5 mai 2025 | Meliani, Chafik |

EPO FORM 1503 03.82 (P04C02)

page 2 de 2

## ANNEXE AU RAPPORT DE RECHERCHE EUROPEENNE
## RELATIF A LA DEMANDE DE BREVET EUROPEEN NO.

EP 25 17 2348

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

05-05-2025

| Document brevet cité au rapport de recherche | | Date de publication | Membre(s) de la famille de brevet(s) | | Date de publication |
|---|---|---|---|---|---|
| WO 0155733 | A1 | 02-08-2001 | AU | 2515500 A | 07-08-2001 |
| | | | BR | 0017072 A | 09-02-2005 |
| | | | EP | 1257832 A1 | 20-11-2002 |
| | | | WO | 0155733 A1 | 02-08-2001 |
| CN 111989901 | B | 18-04-2023 | CA | 3094352 A1 | 31-10-2019 |
| | | | CN | 111989901 A | 24-11-2020 |
| | | | EP | 3785417 A1 | 03-03-2021 |
| | | | US | 2019334932 A1 | 31-10-2019 |
| | | | WO | 2019209796 A1 | 31-10-2019 |
| GB 2538816 | A | 30-11-2016 | AUCUN | | |
| CN 204758133 | U | 11-11-2015 | AUCUN | | |
| US 2024118326 | A1 | 11-04-2024 | EP | 4350364 A1 | 10-04-2024 |
| | | | US | 2024118326 A1 | 11-04-2024 |
| EP 4113131 | A1 | 04-01-2023 | CN | 115541986 A | 30-12-2022 |
| | | | EP | 4113131 A1 | 04-01-2023 |
| | | | FR | 3124600 A1 | 30-12-2022 |
| | | | US | 2022413023 A1 | 29-12-2022 |

EPO FORM P0460

Pour tout renseignement concernant cette annexe : voir Journal Officiel de l'Office européen des brevets, No.12/82